# EUROPEAN PATENT SPECIFICATION

(11) **EP 4 049 882 B1**
(45) Date of publication and mention of the grant of the patent: **01.11.2023**
(21) Application number: 22159017.7
(22) Date of filing: 25.02.2022
(51) Int. Cl.: B60L 3/00, B60L 3/04

(54) **VOLTAGE MONITORING METHOD, VOLTAGE MONITORING APPARATUS, AND ELECTRIC VEHICLE**
SPANNUNGSÜBERWACHUNGSVERFAHREN, SPANNUNGSÜBERWACHUNGSVORRICHTUNG UND ELEKTRISCHES FAHRZEUG
PROCÉDÉ DE SURVEILLANCE DE TENSION, PROCÉDÉ DE SURVEILLANCE DE TENSION, ET VÉHICULE ÉLECTRIQUE

(30) Priority: 26.02.2021 CN 202110223125
(43) Date of publication of application: 31.08.2022
(73) Proprietor: Huawei Digital Power Technologies Co., Ltd., Shenzhen, Guangdong 518043 (CN)
(72) Inventor: KONG, Xuejuan, Shenzhen 518129 (CN); ZHAO, Yunwu, Shenzhen 518129 (CN); ZHANG, Xing, Shenzhen 518129 (CN)
(74) Representative: Gill Jennings & Every LLP

(56) References cited:
- US-A1- 2007 223 262
- US-A1- 2012 280 644
- US-A1- 2013 151 181
- US-B2- 9 234 943

## Description

### TECHNICAL FIELD

This application relates to the field of electric vehicle technologies, and in particular, to a voltage monitoring method, a voltage monitoring apparatus, and an electric vehicle.

### BACKGROUND

As electric vehicle technologies develop, increasing attention is paid to driving safety of the electric vehicles. A power supply, as one of core components of each part of an electric vehicle, is vital for functional safety of the parts. Power supply exceptions include overvoltage, undervoltage, drifts, oscillation, and spikes. When one of the exceptions occurs, fast diagnosis and protection need to be performed. Otherwise, a cascading failure may easily occur, violating safety goals.

For drifts, oscillation, and spikes, it is mainly considered to avoid their occurrences by design. For overvoltage, undervoltage, and parts not covered by design for drifts, oscillation, and spikes, a diagnostic mechanism in D.2.6.2 Voltage or current control (output) in ISO 26262-5 Annex D may be used, to monitor an output voltage of a power supply in real time. The mechanism can reach diagnostic coverage of 99% for a single-point fault metric of the power supply, thereby reaching a level of ASIL D.

US2007223262A1 relates to multiple inverter system with single controller and related operating method. US2012280644A1 relates to inverter and a method for controlling an electric machine. US2013151181A1 relates to determining a battery chemistry for a battery in a peripheral device. US9234943B2 relates to method and system for battery current measurement calibration.

### SUMMARY

An objective of this application is to provide a voltage monitoring method, a voltage monitoring apparatus, and an electric vehicle, to enable a power conversion module to reach a level of ASIL D.

The invention has been defined in the independent claims. Further specific technical features have been defined in the dependent claims.

To resolve the foregoing technical problem, this application provides a voltage monitoring apparatus. The voltage monitoring apparatus includes a power conversion module and a microcontroller electrically connected to the power conversion module. The power conversion module is configured to output a voltage. The microcontroller includes an ADC module, a monitoring module, and an IO module. The ADC module is configured to obtain an output voltage of the power conversion module, and determine whether the output voltage encounters an exception. The monitoring module is configured to: when the output voltage encounters an exception, output a control signal through the IO module. The power conversion module is further configured to stop outputting a voltage based on the control signal. It should be understood that with the voltage monitoring apparatus, diagnostic coverage can reach 99% for an SPFM of the output voltage of the power conversion module, thereby reaching a corresponding level of ASIL D. In addition, because the microcontroller and its peripheral resources are used for implementation, integration can be improved, and BOM costs of an electric vehicle can be reduced, helping control costs of the entire vehicle.

The exception includes overvoltage and undervoltage. When the output voltage is higher than an upper voltage threshold, the output voltage encounters overvoltage. When the output voltage is lower than a lower voltage threshold, the output voltage encounters undervoltage. The upper voltage threshold is greater than the lower voltage threshold.

The microcontroller further includes a self-checking module, a PWM module, and a low-pass filter circuit. The self-checking module is configured to control a duty cycle of a voltage of the PWM module during power-on, so that the PWM module outputs an expected voltage. The expected voltage is transmitted to the ADC module after passing through the low-pass filter circuit, to diagnose whether the ADC module encounters an exception. It should be understood that through cooperation between structures such as the self-checking module, the PWM module, and the low-pass filter circuit, diagnostic coverage can reach 90% for an LFM, thereby reaching the corresponding level of ASIL D and guaranteeing functional safety for the power conversion module.

In some implementations, there are a plurality of power conversion modules, and the monitoring module is further configured to: when the output voltage encounters an exception, identify a power conversion module that encounters an exception, to correspondingly output the control signal. Therefore, the voltage monitoring apparatus can monitor output voltages of the plurality of power conversion modules. When an exception occurs, it is ensured that the electric vehicle enters a controllable safe state, guaranteeing personal safety for driving participants.

In some implementations, the microcontroller further includes an external circuit, the external circuit is electrically connected between the ADC module and the power conversion module, and the output voltage is transmitted to the ADC module after passing through the external circuit.

In some implementations, the external circuit is a bleeder circuit, to divide the output voltage of the power conversion module.

In some implementations, the ADC module triggers an interrupt based on the expected voltage, and the monitoring module is configured to output the control signal to the power conversion module through the IO module during the interrupt, so that the power conversion module stops outputting a voltage, and the ADC module learns through monitoring that the output voltage encounters an exception.

In some implementations, the ADC module is further configured to obtain a range of the output voltage during power-on, and the self-checking module is further configured to diagnose, based on the range of the output voltage, whether the ADC module fails.

In some implementations, the ADC module has a comparator function, to monitor whether the output voltage encounters an exception, and to obtain the range of the output voltage during power-on. With the comparator function, the ADC module can directly perform fast comparison for the output voltage without switching between modes.

In some implementations, the voltage monitoring apparatus is applied to an on-board charger or a motor control unit.

In some implementations, the external circuit is a part of the microcontroller, whereas in some other implementations, the external circuit is located outside the microcontroller.

This application further provides an electric vehicle, including the foregoing voltage monitoring apparatus.

This application further provides a voltage monitoring method, applied to an electric vehicle. The method includes: An ADC module obtains an output voltage of a power conversion module. When the ADC module determines that the output voltage encounters an exception, a monitoring module outputs a control signal to the power conversion module through an IO module, where the exception includes overvoltage or undervoltage. Based on the control signal, the power conversion module is controlled to stop outputting a voltage. It should be understood that with the voltage monitoring method, diagnostic coverage can reach 99% for an SPFM of the output voltage of the power conversion module, thereby reaching a corresponding level of ASIL D. In addition, because a microcontroller and its peripheral resources are used for implementation, integration can be improved, and BOM costs of an electric vehicle can be reduced, helping control costs of the entire vehicle.

The exception includes overvoltage and undervoltage. When the output voltage is higher than an upper voltage threshold, the output voltage encounters overvoltage. When the output voltage is lower than a lower voltage threshold, the output voltage encounters undervoltage. The upper voltage threshold is greater than the lower voltage threshold.

The microcontroller further includes a self-checking module, a PWM module, and a low-pass filter circuit. The self-checking module is configured to control a duty cycle of a voltage of the PWM module during power-on, so that the PWM module outputs an expected voltage. The expected voltage is transmitted to the ADC module after passing through the low-pass filter circuit, to diagnose whether the ADC module encounters an exception. It should be understood that through cooperation between structures such as the self-checking module, the PWM module, and the low-pass filter circuit, diagnostic coverage can reach 90% for an LFM, thereby reaching the corresponding level of ASIL D and guaranteeing functional safety for the power conversion module.

In some implementations, there are a plurality of power conversion modules, and the method further includes: The monitoring module identifies a power conversion module that encounters an exception, to correspondingly output the control signal.

In some implementations, before the ADC module obtains the output voltage of the power conversion module, the method further includes: A bleeder circuit divides and transmits the output voltage to the ADC module.

In some implementations, the method further includes: The ADC module obtains a range of the output voltage during power-on; and the self-checking module diagnoses, based on the range of the output voltage, whether the ADC module and the bleeder circuit fail.

In some implementations, the method further includes: A self-checking module controls a duty cycle of a voltage of a PWM module during power-on, so that the PWM module sends an expected voltage to the ADC module. The ADC module determines, based on the expected voltage, that the output voltage encounters an exception. The monitoring module outputs the control signal through the IO module. Based on the control signal, the power conversion module is controlled to stop outputting a voltage. Based on this, it can be ensured that diagnostic coverage can reach 90% or higher for an LFM, thereby meeting a requirement of the corresponding level of ASIL D and guaranteeing functional safety for the power conversion module.

In this application, the microcontroller and its related peripheral resources are used, so that diagnostic coverage reaches 99% or higher for the SPFM of the voltage monitoring apparatus and 90% or higher for the LFM of the voltage monitoring apparatus, and a corresponding safety level can reach ASIL D, thereby ensuring driving safety for the electric vehicle.

In addition, based on the microcontroller and its related peripheral resources, integration of the voltage monitoring apparatus can be improved while the requirement of ASIL D is met, thereby reducing the BOM costs of the electric vehicle.

### BRIEF DESCRIPTION OF DRAWINGS

FIG. 1 is a diagram of a structure of a voltage monitoring apparatus according to an implementation of this application;
FIG. 2 is a flowchart of a voltage monitoring method according to an implementation of this application;
FIG. 3 is a flowchart of a voltage monitoring method according to another implementation of this application; and
FIG. 4 is a flowchart of a voltage monitoring method according to still another implementation of this application.

### DESCRIPTION OF IMPLEMENTATIONS

To make the objectives, technical solutions, and advantages of this invention clearer, the following further describes various implementations in detail with reference to the accompanying drawings. The implementations described below are not all claimed, they are included to help understanding the context of the invention. While the description refers to various implementations, the embodiments of the invention are those that comprise at least all the features of an independent claim. Any implementation that does not fall within the scope of the claims does not form part of the invention, but rather included as an illustrative example that is useful for understanding the invention.

According to the ISO 26262 standard, a plurality of parts of an electric vehicle need to meet a requirement related to functional safety. Based on this, when the electric vehicle malfunctions, harm caused by the malfunction can be avoided as much as possible, to reduce driving risks for driving participants.

Functional safety is measured by ASILs (Automotive Safety Integration Levels). Hardware architecture metrics include SPFM (Single-Point Fault Metric), LFM (Latent-Fault Metric), and PMHF (Probabilistic Metric for random Hardware Failures). Corresponding ASILs include ASIL A, ASIL B, ASIL C, and ASIL D.

**Table 1**

| | ASIL B | ASIL C | ASIL D |
|---|---|---|---|
| SPFM | ≥ 90% | ≥ 97% | ≥ 99% |
| LFM | ≥ 60% | ≥ 80% | ≥ 90% |
| PMHF | < 10⁻⁷h⁻¹ (100 FIT) | < 10⁻⁸h⁻¹ (100 FIT) | < 10⁻⁸h⁻¹ (10 FIT) |

Table 1 shows relationships between the ASILs and the SPFM, LFM, and PMHF. As shown in Table 1, different ASILs have different requirements for values of the SPFM, LFM, and PMHF. For example, ASIL D requires that diagnostic coverage reach 99% for the SPFM and 90% for the LFM, and less than 10 FIT for the PMHF.

It should be understood that to meet a requirement of a corresponding ASIL, an output voltage of a power conversion module needs to be monitored in real time, to determine whether the power conversion module fails. When the power conversion module fails, some measures need to be taken, to ensure that the entire electric vehicle or parts of the electric vehicle can enter a controllable safe state, to guarantee personal safety for driving participants.

It should be understood that different parts of the electric vehicle may have corresponding safe states in a corresponding scenario. For example, a safe state of an electric-driven system may be stopping outputting torque.

Regarding monitoring of the output voltage of the power conversion module, a safety mechanism is usually added to an existing electric vehicle in a manner of adding a peripheral circuit. For example, to an existing electric vehicle, a circuit for implementing overvoltage diagnosis may be added, a circuit for implementing undervoltage diagnosis may be added, and a circuit for implementing overvoltage and undervoltage diagnosis and self-checking may be correspondingly added. In this way, by using these peripheral circuits, the output voltage of the power conversion module can be monitored. However, because the circuits need to be disposed on a corresponding medium, the manner of adding a peripheral circuit results in an increase in an area of a corresponding circuit board and also a corresponding increase in BOM (Bill of Material) costs of the electric vehicle, and therefore, is unfavorable to control of costs of the entire vehicle.

To resolve the foregoing problem, the implementations of this application provide a voltage monitoring method, a voltage monitoring apparatus, and an electric vehicle using the voltage monitoring apparatus. Both the voltage monitoring method and the voltage monitoring apparatus may be used to monitor an output voltage of a power conversion module, to meet a requirement of a level of ASIL D and ensure functional safety for an electric vehicle. Monitoring of the output voltage is mainly implemented by a microcontroller and its peripheral resources, thereby improving integration, reducing BOM costs of the electric vehicle, and helping control costs of the entire vehicle.

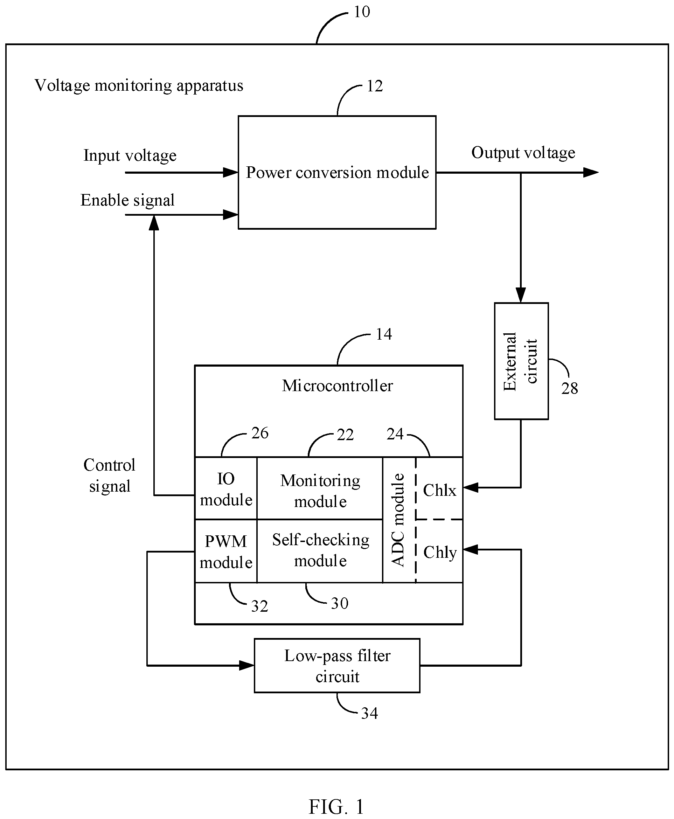

Refer to FIG. 1. An implementation of this application provides a voltage monitoring apparatus 10. The voltage monitoring apparatus 10 includes a power conversion module 12 and a microcontroller 14. The microcontroller 14 is electrically connected to the power conversion module 12 and may monitor an output voltage of the power conversion module 12. Based on this, when the output voltage of the power conversion module 12 encounters an exception such as overvoltage or undervoltage, the microcontroller 14 may control the power conversion module 12 to stop outputting, to ensure functional safety for the power conversion module 12. It should be understood that based on the voltage monitoring apparatus 10 provided in the implementations, the microcontroller 14 can reach diagnostic coverage of 99% for an SPFM of the output voltage, thereby reaching a corresponding level of ASIL D.

In addition, to reach diagnostic coverage of 90% for an LFM, the microcontroller 14 may further perform a self-check operation during power-on in the voltage monitoring apparatus 10 provided in the implementations of this application, to ensure proper implementation of functions of the microcontroller 14. Based on this, the microcontroller 14 can ensure effective monitoring of the output voltage of the power conversion module 12 during driving, thereby reducing potential driving risks.

It should be understood that the voltage monitoring apparatus 10 may perform one self-check within one driving cycle. Based on this, it is ensured that functions of the voltage monitoring apparatus 10 can be properly implemented during driving, thereby ensuring functional safety. One driving cycle may be a cycle of an electric vehicle from power-on, then driving, to power-off. The related self-check operation performed by the voltage monitoring apparatus 10 during power-on may be understood as pre-driving safety mechanism checking of an electric vehicle.

In some implementations, the power conversion module 12 has an input terminal (not shown in the figure) and an output terminal (not shown in the figure). An input voltage is input from the input terminal and converted by the power conversion module 12. The output terminal may correspondingly output the output voltage obtained through conversion. It should be understood that a source of the input voltage may be a 12 V low-voltage battery input, or a high-voltage battery input, or an input from another power conversion module 12. This is not limited in this application.

In some implementations, there may be one, two, or more power conversion modules 12. This is not limited. For ease of understanding, one power conversion module 12 is mainly used as an example for description in the implementations of this application. The technical solutions in the implementations of this application may also be applicable to a case in which there are two or more power conversion modules 12.

It should be understood that the output voltage of the power conversion module 12 is within a specified threshold interval in a normal case. Based on this, the output voltage may be transmitted to other parts of the electric vehicle, so that the other parts implement corresponding functions. For example, the output voltage may enable a motor to implement a function of outputting torque. When the output voltage is outside the threshold interval, it indicates that the output voltage encounters an exception of overvoltage or undervoltage. In this case, the microcontroller 14 may perform a corresponding operation, to ensure that a part of the electric vehicle or the entire electric vehicle can enter a safe state.

In some implementations, there may be an upper voltage threshold and a lower voltage threshold for the output voltage. The threshold interval is between the upper voltage threshold and the lower voltage threshold. In a normal case, the output voltage is between the upper voltage threshold and the lower voltage threshold. When the output voltage is greater than the upper voltage threshold or less than the lower voltage threshold, it indicates that a corresponding power conversion module 12 encounters an exception.

Refer to FIG. 1. In some implementations, to diagnose the foregoing exception, the microcontroller 14 further includes a monitoring module 22, an ADC module 24, and an IO module 26. The monitoring module 22 is electrically connected to the ADC module 24 and the IO module 26, separately.

In some implementations, the ADC module 24 may obtain the output voltage of the power conversion module 12 by using a sampling channel. Through cooperation with an external circuit 28, the ADC module 24 may perform fast comparison for the output voltage. Based on a result of the fast comparison, whether the output voltage encounters an exception such as overvoltage or undervoltage can be determined. The external circuit 28 may be a bleeder circuit or the like. As shown in FIG. 1, the ADC module 24 includes, for example, a sampling channel Chlx and a sampling channel Chly. It should be understood that the ADC module 24 may further include other sampling channels. This is not limited.

In some implementations, the external circuit 28 may be a part of the microcontroller 14, whereas in some other implementations, the external circuit 28 may be located outside the microcontroller 14, and be relatively independent of the microcontroller 14.

It should be understood that overvoltage monitoring is mainly used as an example for description in the implementations of this application, and this is not limited. The voltage monitoring apparatus 10 in the implementations may alternatively be applicable to undervoltage monitoring. For example, the monitoring module 22 in the microcontroller 14 may include an overvoltage monitoring module, which is configured to monitor overvoltage for the output voltage. For another example, the monitoring module 22 may include an undervoltage monitoring module, which is configured to monitor undervoltage for the output voltage.

In some implementations, the ADC module 24 may have a normal mode and a fast compare mode. In normal mode, the ADC module 24 may implement functions such as analog -to-digital conversion. In fast compare mode, the ADC module 24 may perform fast comparison for the output voltage, to determine whether the output voltage encounters an exception such as overvoltage or undervoltage. It should be understood that the ADC module 24 may switch between the normal mode and the fast compare mode based on a use requirement and an application scenario.

In some other implementations, the ADC module 24 may have a comparator function. With the comparator function, the ADC module 24 can directly perform fast comparison for the output voltage without switching between the modes. For example, when the output voltage encounters overvoltage, the ADC module 24 may identify the overvoltage by using the comparator function and trigger an interrupt, so that the monitoring module 22 executes a related program.

In some implementations, the power conversion module 12 further has a controlled terminal, and the controlled terminal may be electrically connected to the IO module 26. Based on this, when the output voltage of the power conversion module 12 encounters an exception, the microcontroller 14 may send a control signal to a corresponding power conversion module 12 through the IO module 26. The control signal may be used to control the power conversion module 12 to stop outputting.

In some implementations, the controlled terminal of the power conversion module 12 may further receive an enable signal. In a normal case, the power conversion module 12 can output the output voltage based on the enable signal. When the enable signal is not received or the enable signal is disabled by the control signal, the power conversion module 12 does not output the output voltage.

For ease of understanding, an example is used for description in which there are a plurality of power conversion modules 12. When learning through monitoring that an output voltage of a power conversion module 12 encounters an exception of overvoltage or undervoltage, the ADC module 24 triggers an interrupt. During the interrupt, the monitoring module 22 may identify a source of the overvoltage, and send the control signal through the IO module 26. Further, the control signal may disable an enable signal of the corresponding power conversion module 12 and make the power conversion module 12 correspondingly stop outputting, to ensure that the electric vehicle enters a controllable safe state, and guarantee personal safety for driving participants. When the output voltage encounters undervoltage, an interrupt processing may alternatively not be performed

It should be understood that because the voltage monitoring apparatus 10 in the implementations monitors the output voltage by using the microcontroller 14, existing peripheral circuits in use such as an external overvoltage monitoring circuit and a self-checking circuit can be cancelled when functional safety is enabled to reach the level of ASIL D. Because these peripheral circuits are cancelled, the voltage monitoring apparatus 10 in the implementations can have higher integration and a circuit board whose area becomes smaller, and BOM costs of the voltage monitoring apparatus 10 can also be reduced.

To meet a requirement of the corresponding level of ASIL D, the voltage monitoring apparatus 10 provided in the implementations of this application further implements a self-check function, to reach diagnostic coverage of 90% for the LFM.

Refer to FIG. 1. In some implementations, the ADC module 24 may diagnose, during power-on, a range of the output voltage transmitted to a corresponding sampling channel, to identify, through diagnosis, a failure of the external circuit 28 and a failure of the ADC module 24. The power-on process may be, for example, a process in which a driving participant turns a key to start an electric vehicle. In addition, the power-on process may alternatively be, for example, a process in which a driving participant starts an electric vehicle by using a smart car key. The smart car key may be, for example, a mobile phone with a corresponding car key function.

It should be understood that the ADC module 24 may diagnose the range of the output voltage of the power conversion module 12. Based on a result of the diagnosis, it can be determined whether the external circuit 28, the ADC module 24, and the corresponding sampling channel operate properly. For example, after the range of the output voltage is diagnosed, a corresponding diagnosis result exceeds a normal range of the output voltage when the external circuit 28 or the ADC module 24 fails, and is within the normal range of the output voltage when the external circuit 28 and the ADC module 24 operate properly.

Refer to FIG. 1. In some implementations, the microcontroller 14 further includes a self-checking module 30, a PWM (Pulse Width Modulation) module 32, and a low-pass filter circuit 34. The self-checking module 30 is electrically connected to the PWM module 32, to control output of the PWM module 32. In addition, the PWM module 32 may also be electrically connected to the low-pass filter circuit 34 and the ADC module 24 sequentially. It should be understood that based on control of a duty cycle of the PWM module 32 by the self-checking module 30, the PWM module 32 sends an expected voltage. The expected voltage is transmitted to a corresponding sampling channel of the ADC module 24 after being filtered by the low-pass filter circuit 34, to diagnose whether the sampling channel can operate properly.

In some implementations, the expected voltage may be greater than the upper voltage threshold. Based on the expected voltage, a fast comparison function of the corresponding sampling channel of the ADC module 24 for overvoltage can be detected. In some other implementations, the expected voltage may be less than the lower voltage threshold. Based on the expected voltage, a fast comparison function of the corresponding sampling channel of the ADC module 24 for undervoltage can be detected.

In some implementations, an example in which the expected voltage is greater than the upper voltage threshold and the monitoring module 22 is an overvoltage monitoring module is used to describe that the sampling channel Chly of the ADC module 24 may respond to the expected voltage from the PWM module 32 when the ADC module 24 operates properly. In this case, the overvoltage monitoring module may output the control signal through the IO module 26, to control a corresponding power conversion module 12 to stop outputting. Because the power conversion module 12 stops outputting, the self-checking module 22 may correspondingly detect that an output voltage of the power conversion module 12 encounters undervoltage. Based on this self-check process, it can be determined that structures of the monitoring apparatus operate properly, thereby guaranteeing functional safety for the electric vehicle and reducing potential driving risks.

In some other implementations, an example in which the expected voltage is less than the lower voltage threshold and the monitoring module 22 is an undervoltage monitoring module is used to describe that the sampling channel Chly of the ADC module 24 may respond to the expected voltage from the PWM module 32 when the ADC module 24 operates properly. In this case, the undervoltage monitoring module may output the control signal through the IO module 26, to control a corresponding power conversion module 12 to stop outputting. Because the power conversion module 12 stops outputting, the monitoring module 22 correspondingly detects that an output voltage of the power conversion module 12 encounters undervoltage.

It should be understood that based on the foregoing self-check process, it can be determined that structures of the voltage monitoring apparatus 10 operate properly. Further, it can be ensured that diagnostic coverage of the voltage monitoring apparatus 10 can reach 90% or higher for the LFM, thereby meeting the requirement of the corresponding level of ASIL D and guaranteeing functional safety for the power conversion module 12.

In some implementations, software used by the voltage monitoring apparatus 10 is developed according to related process requirements in ISO 26262. The software is deployed in the microcontroller 14 with a lockstep core, to enable a corresponding chip safety mechanism. Therefore, in the power-on process, diagnostic coverage of the microcontroller 14 can reach 90% or higher for the LFM, thereby reaching the corresponding level of ASIL D.

In some implementations, the voltage monitoring apparatus 10 may be an on-board charger or a motor control unit. This is not limited. When the voltage monitoring apparatus 10 is an electric-driven system, the electric-driven system may further include structures such as a motor.

In some implementations, the microcontroller 14 may be disposed in the voltage monitoring apparatus 10 in a form of a chip. It should be understood that in the voltage monitoring apparatuses in the implementations of this application, a form in which the microcontroller 14 is presented is not limited.

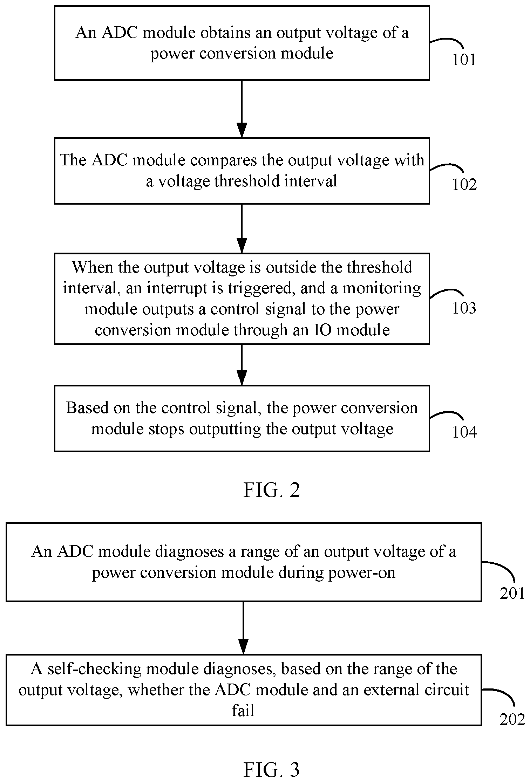

Refer to both FIG. 1 and FIG. 2. An implementation of this application further provides a voltage monitoring method. Similar to the voltage monitoring apparatuses 10 in the foregoing implementations, the voltage monitoring method may be applied to an electric vehicle, to monitor an output voltage of a power conversion module 12.

In some implementations, the voltage monitoring method includes but is not limited to the following steps.

101. An ADC module obtains an output voltage of a power conversion module.

In some implementations, the ADC module may be further electrically connected to an external circuit such as a bleeder circuit. The output voltage of the power conversion module is divided by the bleeder circuit and then sent to a corresponding sampling channel of the ADC module.

102. The ADC module compares the output voltage with a voltage threshold interval.

In some implementations, the ADC module may have a normal mode and a fast compare mode. In normal mode, the ADC module may implement functions such as analog-to-digital conversion. In fast compare mode, the ADC module may perform fast comparison for the output voltage, to determine whether the output voltage encounters an exception of overvoltage or undervoltage. It should be understood that the mode of the ADC module may be switched based on a use requirement.

In some other implementations, the ADC module may have a comparator function. With the comparator function, the ADC module can directly perform fast comparison for the output voltage without switching between the modes. For example, when the output voltage encounters overvoltage, the ADC module may identify overvoltage by using the comparator function and trigger an interrupt, so that a monitoring module executes a related program.

103. When the output voltage is outside the threshold interval, the monitoring module outputs a control signal to the power conversion module through the IO module.

There may be an upper voltage threshold and a lower voltage threshold for the output voltage. The threshold interval is between the upper voltage threshold and the lower voltage threshold. It should be understood that when the power conversion module operates properly, the output voltage of the power conversion module is between the upper voltage threshold and the lower voltage threshold, whereas when the power conversion module encounters an exception, the output voltage of the power conversion module falls outside the threshold interval. For example, when the output voltage is greater than the upper voltage threshold, it indicates that the corresponding output voltage encounters an exception of overvoltage, or when the output voltage is less than the lower voltage threshold, it indicates that the corresponding output voltage encounters an exception of undervoltage. It should be understood that when the output voltage encounters overvoltage, interrupt processing is performed, whereas when the output voltage encounters undervoltage, interrupt processing may not be performed.

104. Based on the control signal, the power conversion module stops outputting the output voltage.

It should be understood that for the exception of overvoltage or undervoltage, a corresponding measure needs to be taken to avoid risks and ensure functional safety. In the voltage monitoring method in the implementations of this application, overvoltage monitoring is mainly used as an example for description, and this is not limited. The voltage monitoring method in the implementations may also be applied to undervoltage monitoring, and this is not limited.

In some implementations, the power conversion module may receive an enable signal. In a normal case, the power conversion module can output the output voltage based on the enable signal. When the enable signal is not received, the power conversion module does not output the output voltage. The control signal output through the IO module may disable the enable signal, to make the corresponding power conversion module stop outputting.

For ease of understanding, an example is used for description in which there are a plurality of power conversion modules and an output voltage encounters overvoltage. When learning through monitoring that an output voltage of a power conversion module encounters an exception of overvoltage, the ADC module triggers an interrupt. During the interrupt, the monitoring module may identify a source of the overvoltage, and send the control signal through the IO module. The control signal may disable an enable signal of the corresponding power conversion module and make the power conversion module correspondingly stop outputting, to ensure that an electric vehicle enters a controllable safe state, and guarantee personal safety for driving participants.

It should be understood that, in the voltage monitoring method provided in the implementations, a related safety measure is implemented by using related peripheral resources of a microcontroller. To be specific, when the voltage monitoring method is used, functional safety of the corresponding power conversion module can reach a level of ASIL D, and existing peripheral circuits in use such as an external overvoltage monitoring circuit and a self-checking circuit can be cancelled, thereby improving integration and reducing BOM costs of a voltage monitoring apparatus.

Refer to both FIG. 2 and FIG. 3. The voltage monitoring method provided in this implementation of this application may further include but is not limited to the following steps.

201. The ADC module diagnoses a range of the output voltage of the power conversion module during power-on.

It should be understood that the diagnosis of the range of the output voltage may be implemented by the ADC module in normal mode.

202. A self-checking module diagnoses, based on the range of the output voltage, whether the ADC module and the external circuit fail.

It should be understood that whether the external circuit, the ADC module, and the corresponding sampling channel of the ADC module fail can be diagnosed during power-on based on the diagnosis of the range of the output voltage. For example, after the range of the output voltage is diagnosed, a corresponding diagnosis result exceeds a normal range of the output voltage when the external circuit or the ADC module fails, and is within the normal range of the output voltage when the external circuit and the ADC module operate properly.

Refer to FIG. 2, FIG. 3, and FIG. 4 together. The voltage monitoring method provided in this implementation of this application may further include but is not limited to the following steps.

301. A PWM module sends an expected voltage to the ADC module during power-on.

It should be understood that based on control of a duty cycle of the PWM module by the self-checking module, the PWM module can be enabled to send an expected voltage with a corresponding duty cycle.

302. Trigger a fast comparison function of the ADC module based on the expected voltage.

In some implementations, the ADC module has a normal mode and a fast compare mode. The ADC module switches from the normal mode to the fast compare mode through software control, to diagnose the fast comparison function of the ADC module.

In some other implementations, the ADC module may have the comparator function. The comparator function of the ADC module can be diagnosed based on the expected voltage.

As described above, the expected voltage may be greater than the upper voltage threshold. Based on the expected voltage, a fast comparison function of the corresponding sampling channel of the ADC module for overvoltage can be detected. In some other implementations, the expected voltage may be less than the lower voltage threshold. Based on the expected voltage, a fast comparison function of the corresponding sampling channel of the ADC module for undervoltage can be detected.

303. The monitoring module outputs the control signal to the power conversion module through the IO module.

In some implementations, an example in which the expected voltage is greater than the upper voltage threshold is used to describe that a sampling channel Chly of the ADC module may respond to the expected voltage from the PWM module when the ADC module operates properly. In this case, the monitoring module may output the control signal through the IO module.

304. Based on the control signal, the power conversion module stops outputting the output voltage.

In some implementations, as described above, the control signal may make a corresponding power conversion module stop outputting, and the monitoring module may correspondingly detect that the output voltage of the power conversion module encounters undervoltage. Based on this process, it can be determined that structures of the monitoring apparatus operate properly, thereby guaranteeing functional safety for the electric vehicle and reducing potential driving risks.

In some other implementations, an example in which the expected voltage is less than the lower voltage threshold is used to describe that the sampling channel Chly of the ADC module may respond to the expected voltage from the PWM module when the ADC module operates properly. In this case, an undervoltage monitoring module may output the control signal through the IO module, to control a corresponding power conversion module to stop outputting. Because the power conversion module stops outputting, the monitoring module correspondingly detects that an output voltage of the power conversion module encounters undervoltage.

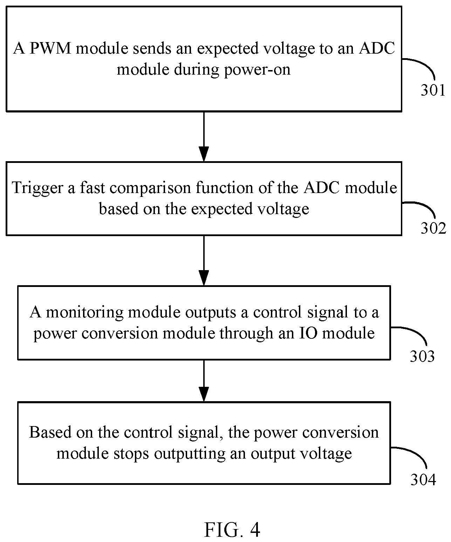

Refer to both FIG. 3 and FIG. 4. It can be correspondingly diagnosed based on the voltage monitoring method in the foregoing implementations whether structures such as the ADC module, the external circuit, and the monitoring module operate properly. Therefore, it can be ensured that diagnostic coverage can reach 90% or higher for an LFM, thereby meeting a requirement of the corresponding level of ASIL D and guaranteeing functional safety for the power conversion module. In both the voltage monitoring method and the voltage self-check method provided in the implementations of this application, related structures of the microcontroller are used to reach the corresponding level of ASIL D. Correspondingly, peripheral circuits required in the conventional technology can be cancelled, thereby reducing costs of and improving integration of the voltage monitoring apparatus.

The scope of protection is defined by the appended claims.

## Claims

1. A voltage monitoring apparatus (10), suitable for use in an electric vehicle, wherein the voltage monitoring apparatus comprises a power conversion module (12) and a microcontroller (14) electrically connected to the power conversion module;
the power conversion module is configured to output a voltage;
the microcontroller comprises an Analog-to-Digital Conversion, ADC module (24), a monitoring module (22), and an IO module (26), wherein
the ADC module is configured to obtain an output voltage of the power conversion module, and determine whether the output voltage encounters an exception; and
the monitoring module is configured to: when the output voltage encounters an exception, output a control signal through the IO module; and
the power conversion module is further configured to stop outputting the voltage based on the control signal;
wherein the exception comprises overvoltage and undervoltage; when the output voltage is higher than an upper voltage threshold, the output voltage encounters overvoltage; when the output voltage is lower than a lower voltage threshold, the output voltage encounters undervoltage; and the upper voltage threshold is greater than the lower voltage threshold;
**characterised in that**
the microcontroller further comprises a self-checking module (30), a PWM module (32), and a low-pass filter circuit (34); and
the self-checking module is configured to control a duty cycle of a voltage of the PWM module during power-on, so that the PWM module outputs an expected voltage, wherein the expected voltage is transmitted to the ADC module after passing through the low-pass filter circuit, to diagnose whether the ADC module encounters an exception.

2. The voltage monitoring apparatus according to claim 1, wherein there are a plurality of power conversion modules, and the monitoring module is further configured to: when the output voltage encounters an exception, identify a power conversion module that encounters an exception, to correspondingly output the control signal.

3. The voltage monitoring apparatus according to claim 1 or 2, wherein the microcontroller further comprises an external circuit (28), the external circuit is electrically connected between the ADC module and the power conversion module, and the output voltage is transmitted to the ADC module after passing through the external circuit.

4. The voltage monitoring apparatus according to claim 3, wherein the external circuit is a bleeder circuit.

5. The voltage monitoring apparatus according to any one of claims 1 to 4, wherein the ADC module triggers an interrupt based on the expected voltage, and the monitoring module is configured to output the control signal to the power conversion module through the IO module during the interrupt, so that the power conversion module stops outputting a voltage, and the ADC module learns through monitoring that the output voltage encounters an exception.

6. The voltage monitoring apparatus according to claim 6, wherein the ADC module is further configured to obtain a range of the output voltage during power-on, and the self-checking module is further configured to diagnose, based on the range of the output voltage, whether the ADC module fails.

7. The voltage monitoring apparatus according to claim 6, wherein the ADC module has a comparator function, to monitor whether the output voltage encounters an exception, and to obtain the range of the output voltage during power-on.

8. An electric vehicle, comprising the voltage monitoring apparatus according to any one of claims 1 to 7.

9. A voltage monitoring method, applied to an electric vehicle, the voltage monitoring method comprises:
obtaining (101), by an ADC module, an output voltage of a power conversion module;
when the ADC module determines that the output voltage encounters an exception, outputting (102, 103), by a monitoring module, a control signal to the power conversion module through an IO module, wherein the exception comprises overvoltage or undervoltage; and
controlling (103, 104), based on the control signal, the power conversion module to stop outputting the voltage;
wherein the exception comprises overvoltage and undervoltage; when the output voltage is higher than an upper voltage threshold, the output voltage encounters overvoltage; when the output voltage is lower than a lower voltage threshold, the output voltage encounters undervoltage; and the upper voltage threshold is greater than the lower voltage threshold;
**characterised in that** the method further comprises:
controlling, by a self-checking module, a duty cycle of a voltage of a PWM module during power-on, so that the PWM module outputs an expected voltage, and
transmitting, by the self-checking module, the expected voltage to the ADC module after passing through the low-pass filter circuit, to diagnose whether the ADC module encounters an exception.

10. The voltage monitoring method according to claim 9, wherein there are a plurality of power conversion modules, and the method further comprises:
identifying, by the monitoring module, a power conversion module that encounters an exception, to correspondingly output the control signal.

11. The voltage monitoring method according to claim 9 or 10, before the obtaining, by an ADC module, an output voltage of a power conversion module, further comprising: dividing, by a bleeder circuit, the output voltage, and transmitting the output voltage to the ADC module.

12. The voltage monitoring method according to claim 11, wherein the method further comprises:
obtaining, by the ADC module, a range of the output voltage during power-on; and
diagnosing, by the self-checking module based on the range of the output voltage, whether the ADC module and the bleeder circuit fail.

13. The voltage monitoring method according to claim 11, wherein the method further comprises:
controlling, by a self-checking module, a duty cycle of a voltage of a PWM module during power-on, so that the PWM module sends an expected voltage to the ADC module;
determining, by the ADC module based on the expected voltage, that the output voltage encounters an exception;
outputting, by the monitoring module, the control signal through the IO module; and
controlling, based on the control signal, the power conversion module to stop outputting a voltage.

## Patentansprüche

1. Spannungsüberwachungsvorrichtung (10), die sich zur Verwendung in einem Elektrofahrzeug eignet, wobei die Spannungsüberwachungsvorrichtung ein Leistungsumwandlungsmodul (12) und einen Mikrocontroller (14) umfasst, der mit dem Leistungsumwandlungsmodul elektrisch verbunden ist;
das Leistungsumwandlungsmodul zum Ausgeben einer Spannung konfiguriert ist; der Mikrocontroller ein Analog-Digital-Umwandlungs-,ADC-,Modul (24), ein Überwachungsmodul (22) und ein EA-Modul (26) umfasst, wobei das ADC-Modul zum Erhalten einer Ausgangsspannung des Leistungsumwandlungsmoduls und Bestimmen konfiguriert ist, ob bei der Ausgangsspannung eine Ausnahme auftritt, und
das Überwachungsmodul konfiguriert ist zum: Ausgeben eines Steuersignals über das EA-Modul, wenn bei der Ausgangsspannung eine Ausnahme auftritt, und
das Leistungsumwandlungsmodul ferner so konfiguriert ist, dass es das Ausgeben der Spannung basierend auf dem Steuersignal stoppt,
wobei die Ausnahme eine Überspannung und eine Unterspannung umfasst; wobei Überspannung bei der Ausgangsspannung auftritt, wenn die Ausgangsspannung höher als eine obere Spannungsschwelle ist; Unterspannung bei der Ausgangsspannung auftritt, wenn die Ausgangsspannung niedriger als eine untere Spannungsschwelle ist; und die obere Spannungsschwelle größer als die untere Spannungsschwelle ist; **dadurch gekennzeichnet, dass**
der Mikrocontroller ferner ein Selbstprüfmodul (30), ein PWM-Modul (32) und eine Tiefpassfilterschaltung (34) umfasst; und
das Selbstprüfmodul zum Steuern eines Tastverhältnisses einer Spannung des PWM-Moduls während des Einschaltens konfiguriert ist, so dass das PWM-Modul eine erwartete Spannung ausgibt, wobei die erwartete Spannung nach dem Passieren der Tiefpassfilterschaltung an das ADC-Modul übertragen wird, um zu diagnostizieren, ob eine Ausnahme beim ADC-Modul auftritt.

2. Spannungsüberwachungsvorrichtung nach Anspruch 1, wobei es eine Mehrzahl von Leistungsumwandlungsmodulen gibt und das Überwachungsmodul ferner konfiguriert ist zum: Identifizieren eines Leistungsumwandlungsmoduls, bei dem eine Ausnahme auftritt, bei Auftreten einer Ausnahme bei der Ausgangsspannung, um dementsprechend ein Steuersignal auszugeben.

3. Spannungsüberwachungsvorrichtung nach Anspruch 1 oder 2, wobei der Mikrocontroller eine externe Schaltung (28) umfasst, die externe Schaltung elektrisch zwischen das ADC-Modul und das Leistungsumwandlungsmodul geschaltet ist, und die Ausgangsspannung nach dem Passieren der externen Schaltung an das ADC-Modul übertragen wird.

4. Spannungsüberwachungsvorrichtung nach Anspruch 3, wobei die externe Schaltung eine Spannungsteilerschaltung ist.

5. Spannungsüberwachungsvorrichtung nach einem der Ansprüche 1 bis 4, wobei das ADC-Modul basierend auf der erwarteten Spannung eine Unterbrechung auslöst und das Überwachungsmodul so konfiguriert ist, dass es während der Unterbrechung ein Steuersignal über das EA-Modul an das Leistungsüberwachungsmodul ausgibt, so dass das Leistungsüberwachungsmodul das Ausgeben der Spannung stoppt, und das ADC-Modul durch Überwachen lernt, dass bei der Ausgangsspannung eine Ausnahme auftritt.

6. Spannungsüberwachungsvorrichtung nach Anspruch 6, wobei das ADC-Modul ferner so konfiguriert ist, dass es einen Bereich der Ausgangsspannung während des Einschaltens erhält, und das Selbstprüfmodul ferner so konfiguriert ist, dass es basierend auf dem Bereich der Ausgangsspannung diagnostiziert, ob das ADC-Modul ausfällt.

7. Spannungsüberwachungsvorrichtung nach Anspruch 6, wobei das ADC-Modul eine Komparatorfunktion aufweist, um zu überwachen, ob bei der Ausgangsspannung eine Ausnahme auftritt, und um den Bereich der Ausgangsspannung während des Einschaltens zu erhalten.

8. Elektrofahrzeug, umfassend die Spannungsüberwachungsvorrichtung nach einem der Ansprüche 1 bis 7.

9. Spannungsüberwachungsverfahren, das auf ein Elektrofahrzeug angewendet wird, wobei das Spannungsüberwachungsverfahren umfasst:
Erhalten (101) einer Ausgangsspannung eines Leistungsumwandlungsmoduls durch ein ADC-Modul,
Ausgeben (102, 103) eines Steuersignals durch ein Überwachungsmodul über ein EA-Modul an das Leistungsumwandlungsmodul, wenn das ADC-Modul bestimmt, dass bei der Ausgangsspannung eine Ausnahme auftritt, wobei die Ausnahme Überspannung oder Unterspannung umfasst; und
Steuern (103, 104) des Leistungsumwandlungsmoduls basierend auf dem Steuersignal, um Ausgeben der Spannung zu stoppen;
wobei die Ausnahme Überspannung und Unterspannung umfasst; wobei Überspannung bei der Ausgangsspannung auftritt, wenn die Ausgangsspannung höher als eine obere Spannungsschwelle ist; Unterspannung bei der Ausgangsspannung auftritt, wenn die Ausgangsspannung niedriger als eine untere Spannungsschwelle ist; und die obere Spannungsschwelle größer als die untere Spannungsschwelle ist;
**dadurch gekennzeichnet, dass** das Verfahren ferner umfasst:
Steuern eines Tastverhältnisses einer Spannung eines PWM-Moduls während des Einschaltens, so dass das PWM-Modul eine erwartete Spannung ausgibt, durch ein Selbstprüfmodul und
Übertragen der erwarteten Spannung nach dem Passieren der Tiefpassfilterschaltung durch das Selbstprüfmodul an das ADC-Modul, um zu diagnostizieren, ob beim ADC-Modul eine Ausnahme auftritt.

10. Spannungsüberwachungsverfahren nach Anspruch 9, wobei es eine Mehrzahl von Leistungsumwandlungsmodulen gibt und das Verfahren ferner umfasst:
Identifizieren eines Leistungsumwandlungsmoduls, bei dem eine Ausnahme auftritt, durch das Überwachungsmodul, um dementsprechend das Steuersignal auszugeben.

11. Spannungsüberwachungsverfahren nach Anspruch 9 oder 10, ferner umfassend vor dem Erhalten einer Ausgangsspannung eines Leistungsumwandlungsmoduls durch ein ADC-Modul: Teilen der Ausgangsspannung durch eine Spannungsteilerschaltung und Übertragen der Ausgangsspannung an das ADC-Modul.

12. Spannungsüberwachungsverfahren nach Anspruch 11, wobei das Verfahren ferner umfasst:
Erhalten durch das ADC-Modul eines Bereichs der Ausgangsspannung während des Einschaltens, und
Diagnostizieren, ob das ADC-Modul und die Spannungsteilerschaltung ausfallen, durch das Selbstprüfmodul basierend auf dem Bereich der Ausgangsspannung.

13. Spannungsüberwachungsverfahren nach Anspruch 11, wobei das Verfahren ferner umfasst:
Steuern eines Tastverhältnisses einer Spannung eines PWM-Moduls während des Einschaltens, so dass das PWM-Modul eine erwartete Spannung an das ADC-Modul sendet, durch ein Selbstprüfmodul und
Bestimmen, dass bei der Ausgangsspannung eine Ausnahme auftritt, durch das ADC-Modul basierend auf der erwarteten Spannung;
Ausgeben des Steuersignals durch das Überwachungsmodul über das EA-Modul, und Steuern des Leistungsumwandlungsmoduls basierend auf dem Steuersignal, um das Ausgeben der Spannung zu stoppen.

## Revendications

1. Appareil de surveillance de tension (10), susceptible d'être utilisé dans un véhicule électrique, l'appareil de surveillance de tension comprenant un module de conversion de puissance (12) et un microcontrôleur (14) connecté électriquement au module de conversion de puissance ;
le module de conversion de puissance étant configuré pour délivrer une tension ;
le microcontrôleur comprenant un module de conversion analogique-numérique, ADC, (24), un module de surveillance (22) et un module IO (26),
le module ADC étant configuré pour obtenir une tension de sortie du module de conversion de puissance et déterminer si la tension de sortie rencontre ou non une exception ; et
le module de surveillance étant configuré pour : lorsque la tension de sortie rencontre une exception, délivrer un signal de commande via le module IO ; et
le module de conversion de puissance étant configuré en outre pour cesser de délivrer la tension sur la base du signal de commande ;
l'exception comprenant une surtension et une sous-tension ; lorsque la tension de sortie est plus élevée qu'un seuil supérieur de tension, la tension de sortie rencontrant une surtension ; lorsque la tension de sortie est inférieure à un seuil inférieur de tension, la tension de sortie rencontrant une sous-tension ; et le seuil supérieur de tension étant plus grand que le seuil inférieur de tension ;
**caractérisé en ce que**
le microcontrôleur comprend en outre un module d'auto-contrôle (30), un module PWM (32) et un circuit filtre passe-bas (34) ; et
le module d'auto-contrôle est configuré pour commander un rapport cyclique d'une tension du module PWM durant la mise sous tension, de sorte que le module PWM délivre une tension attendue, la tension attendue étant transmise au module ADC après avoir traversé le circuit filtre passe-bas, afin de diagnostiquer si le module ADC rencontre ou non une exception.

2. Appareil de surveillance de tension selon la revendication 1, dans lequel une pluralité de modules de conversion de puissance sont présents, et le module de surveillance est configuré en outre pour : lorsque la tension de sortie rencontre une exception, identifier un module de conversion de puissance qui rencontre une exception, afin de délivrer corrélativement le signal de commande.

3. Appareil de surveillance de tension selon la revendication 1 ou 2, dans lequel le microcontrôleur comprend en outre un circuit externe (28), le circuit externe est connecté électriquement entre le module ADC et le module de conversion de puissance, et la tension de sortie est transmise au module ADC après avoir traversé le circuit externe.

4. Appareil de surveillance de tension selon la revendication 3, dans lequel le circuit externe est un circuit diviseur de tension.

5. Appareil de surveillance de tension selon l'une quelconque des revendications 1 à 4, dans lequel le module ADC déclenche une interruption sur la base de la tension attendue, et le module de surveillance est configuré pour délivrer le signal de commande au module de conversion de puissance via le module IO durant l'interruption, de sorte que le module de conversion de puissance cesse de délivrer une tension, et le module ADC apprend, grâce à la surveillance, que la tension de sortie rencontre une exception.

6. Appareil de surveillance de tension selon la revendication 6, dans lequel le module ADC est configuré en outre pour obtenir une plage de la tension de sortie au cours de la mise sous tension, et le module d'auto-contrôle est configuré en outre pour diagnostiquer, sur la base de la plage de la tension de sortie, si le module ADC connaît ou non une défaillance.

7. Appareil de surveillance de tension selon la revendication 6, dans lequel le module ADC est pourvu d'une fonction de comparaison pour surveiller si la tension de sortie rencontre ou non une exception et pour obtenir la plage de la tension de sortie au cours de la mise sous tension.

8. Véhicule électrique, comprenant l'appareil de surveillance de tension selon l'une quelconque des revendications 1 à 7.

9. Procédé de surveillance de tension, appliqué à un véhicule électrique, le procédé de surveillance de tension comprenant :
l'obtention (101), par un module ADC, d'une tension de sortie d'un module de conversion de puissance ;
lorsque le module ADC détermine que la tension de sortie rencontre une exception, la délivrance (102, 103), par un module de surveillance, d'un signal de commande au module de conversion de puissance via un module IO, l'exception comprenant une surtension ou une sous-tension ; et
la commande (103, 104), sur la base du signal de commande, au module de conversion de puissance de cesser de délivrer la tension ;
l'exception comprenant une surtension et une sous-tension ; lorsque la tension de sortie est plus élevée qu'un seuil supérieur de tension, la tension de sortie rencontrant une surtension ; lorsque la tension de sortie est inférieure à un seuil inférieur de tension, la tension de sortie rencontrant une sous-tension ; et le seuil supérieur de tension étant plus grand que le seuil inférieur de tension ;
le procédé étant **caractérisé en ce qu'**il comprend en outre :
la commande, par un module d'auto-contrôle, d'un rapport cyclique d'une tension d'un module PWM au cours de la mise sous tension, de sorte que le module PWM délivre une tension attendue, et
la transmission, par le module d'auto-contrôle, de la tension attendue au module ADC après qu'elle a traversé le circuit filtre passe-bas, afin de diagnostiquer si le module ADC rencontre ou non une exception.

10. Procédé de surveillance de tension selon la revendication 9, dans lequel une pluralité de modules de conversion de puissance sont présents, et le procédé comprenant en outre :
l'identification, par le module de surveillance, d'un module de conversion de puissance qui rencontre une exception, afin de délivrer corrélativement le signal de commande.

11. Procédé de surveillance de tension selon la revendication 9 ou 10, comprenant en outre, avant l'obtention, par un module ADC, d'une tension de sortie d'un module de conversion de puissance : la division, par un circuit diviseur de tension, de la tension de sortie et la transmission de la tension de sortie au module ADC.

12. Procédé de surveillance de tension selon la revendication 11, le procédé comprenant en outre :
l'obtention, par le module ADC, d'une plage de la tension de sortie au cours de la mise sous tension ; et
le diagnostic, par le module d'auto-contrôle sur la base de la plage de la tension de sortie, si le module ADC et le circuit diviseur de tension connaissent ou non une défaillance.

13. Procédé de surveillance de tension selon la revendication 11, le procédé comprenant en outre :
la commande, par un module d'auto-contrôle, d'un rapport cyclique d'une tension d'un module PWM au cours de la mise sous tension, de sorte que le module PWM envoie une tension attendue au module ADC ;
la détermination, par le module ADC sur la base de la tension attendue, que la tension de sortie rencontre une exception ;
la délivrance, par le module de surveillance, du signal de commande via la module IO ; et
la commande, sur la base du signal de commande, au module de conversion de puissance de cesser de délivrer une tension.
